# DEMANDE DE BREVET EUROPEEN

(11) **EP 4 761 527 A1**
(43) Date de publication de la demande: **17.06.2026**
(21) Numéro de dépôt: 25211384.0
(22) Date de dépôt: 27.10.2025
(51) Int. Cl.: H10H 20/01, H10H 20/815

(54) **PROCÉDÉ DE FABRICATION D'UNE DIODE ÉLECTROLUMINESCENTE**

(30) Priorité: 12.12.2024 FR 2414026
(71) Demandeur: Commissariat à l'Energie Atomique et aux Energies Alternatives, 75015 Paris (FR)
(72) Inventeur: DUPONT, Florian, 38054 GRENOBLE CEDEX 09 (FR); GUY, Kevin, 38054 GRENOBLE CEDEX 09 (FR)
(74) Mandataire: Atout PI Laplace

(57) **Abrégé**

L'invention concerne un procédé de fabrication d'une diode électroluminescente comprenant :
- disposer d'un substrat en saphir ;
- déposer une couche intermédiaire épitaxiée sur le substrat en nitrure de métaux de transition choisis parmi : TiN, ZrN, HfN, NbN, TaN, VN, MoN, WN, CrN ;
- déposer une couche tampon sur la couche intermédiaire de manière à obtenir une couche épitaxiée, la couche tampon étant en AlₓGa₁₋ₓN avec 0≤x≤1 ;
- déposer, sur la couche tampon, un empilement de diode électroluminescente comprenant une couche active, et une couche d'injection de part et d'autre de la couche active ;
- coller un substrat de report sur l'empilement grâce à une couche de collage ; et
- effectuer un détachement par laser du substrat en appliquant un rayon laser à travers le substrat et la couche intermédiaire, le rayon laser ayant une longueur d'onde d'émission absorbée par la couche intermédiaire.

## Description

### DOMAINE TECHNIQUE

L'invention concerne un procédé de fabrication d'une diode électroluminescente, et notamment un procédé de fabrication d'une diode électroluminescente utilisant le détachement par laser d'un substrat en saphir.

### ETAT DE LA TECHNIQUE

La fabrication des diodes électroluminescentes sur un substrat en saphir présente de nombreux avantages, comme par exemple la compatibilité en termes de paramètre de maille avec un matériau actif en AlGaN utilisé pour les diodes électroluminescentes émettant dans l'UV et la limitation des défauts de fabrication des différentes couches des diodes électroluminescentes.

Cependant, le saphir est un matériau ayant un indice de réfraction très supérieur à celui de l'air. Cette différence d'indice de réfraction engendre un angle critique, c'est-à-dire l'angle d'incidence maximum pour lequel un photon peut s'échapper de la diode électroluminescente, qui est faible à l'interface entre l'air et le saphir. Cela induit une réflexion interne importante des photons émis par la couche active dans la diode électroluminescente. Les photons ne peuvent donc pas s'échapper de la diode électroluminescente et sont ainsi perdus pour l'émission dans l'air. Ainsi, les diodes électroluminescentes de l'état de l'art comprenant un substrat en saphir présentent une efficacité d'extraction de la lumière (light extraction efficiency en anglais, dite LEE) faible.

Une solution pour augmenter l'efficacité d'extraction de la lumière des diodes électroluminescentes sur substrat en saphir est de rendre rugueuse (« rugosifier ») la face du substrat en saphir qui est en contact avec l'air. Cela permet de modifier d'angle d'incidence des photons et donc l'angle critique. Cependant, le saphir est un matériau dur qui est donc difficile et coûteux à rugosifier.

Une autre solution est d'utiliser des substrats en AIN qui a un indice de réfraction moins éloigné de celui de l'air que celui du saphir. Cependant, les substrats en AIN existants possèdent des épaisseurs trop fines et/ou sont trop couteux pour les applications commerciales.

Une autre solution est de retirer le substrat en saphir une fois la diode électroluminescente fabriquée, par détachement par laser (lift off en anglais). Ce procédé est déjà utilisé pour les diodes électroluminescentes bleues et dans l'UV-A (entre 315 et 400 nm), en utilisant une couche tampon en GaN déposée entre le substrat en saphir et les autres couches de fonction de la diode. La couche tampon en GaN permet une forte absorption du rayon laser émis pour réaliser le détachement, et ainsi de décoller le substrat en saphir (voir par exemple, Kawan, A. et al. Trans. Elec. Mat. 2021 (22), 128-132). Cependant, l'utilisation de la couche tampon en GaN n'est pas possible à des longueurs d'onde dans L'UV-C (entre 100 nm et 280 nm) car le GaN absorbe les longueurs d'onde dans L'UV-C et donc celles émises par la diode électroluminescente elle-même. De plus, dans l'UV-A, une couche tampon en GaN ayant une épaisseur élevée est nécessaire afin de réaliser le détachement par laser, entrainant un temps de dépôt important. En outre, la différence de paramètre de maille entre le GaN et un matériau actif en AlGaN utilisé pour les diodes électroluminescentes émettant dans l'UV entraine des défauts importants dans les couches déposées au-dessus de la couche tampon.

Une couche tampon en AIN permettrait de réduire les défauts dans les couches déposées au-dessus de la couche tampon, compte tenu des paramètres de mailles de l'AIN, plus proches de ceux de AlGaN. Des résultats ont été démontrés avec des couches tampons en AIN, qui engendrerait un moins grand nombre de défauts de fabrication. Cependant, dans l'état de l'art, le détachement par laser des substrats en saphir avec une couche tampon en AIN nécessite une densité d'énergie environ quatre fois plus élevée que celle utilisée avec une couche tampon en GaN (voir par exemple Aoshima, H. et al. Phys. Status. Solidi 2012, 753-756). De plus, la densité d'énergie élevée du laser détériore les autres couches de la diode électroluminescente.

### RESUME

Afin de pallier les inconvénients précités des sources lasers, l'invention propose un procédé de fabrication d'une diode électroluminescente, le procédé comprenant les étapes suivantes :
a- disposer d'un substrat en saphir ;
b- déposer une couche dite intermédiaire sur le substrat de manière à obtenir une couche intermédiaire épitaxiée, la couche intermédiaire étant en nitrure de métaux de transition choisis parmi : TiN, ZrN, HfN, NbN, TaN, VN, MoN, WN, CrN ;
c- déposer une couche dite tampon sur la couche intermédiaire de manière à obtenir une couche épitaxiée, la couche tampon étant en matériau AlxGa1-xN avec 0<x<1 ;
d- déposer, sur la couche tampon, un empilement réalisant une fonction de diode électroluminescente, l'empilement comprenant au moins une couche active, et une couche d'injection de part et d'autre de la couche active ;
e- coller un substrat dit de report sur l'empilement grâce à au moins une couche de collage ; et
f- effectuer un détachement par laser du substrat en saphir en appliquant un rayon laser au moins à travers le substrat en saphir et la couche intermédiaire, le rayon laser ayant une longueur d'onde d'émission configurée pour être absorbée par la couche intermédiaire.

Dans un mode de réalisation, le procédé comprend en outre l'étape suivante, réalisée après l'étape d) : d'- effectuer un recuit du substrat, de la couche tampon et de la couche intermédiaire à une température supérieure à 1500°C ;

Dans un mode de réalisation, la couche tampon comprend une première face en contact avec l'empilement et une deuxième face opposée à la première face, le procédé comprenant en outre l'étape suivante, réalisée après l'étape f) :
g- rendre rugueuse la deuxième face de la couche tampon ;

Dans un mode de réalisation, la couche intermédiaire a une épaisseur comprise entre 5 et 50 nm.

Dans un mode de réalisation, l'étape e) de collage s'effectue en disposant une couche de collage sur le substrat de report ou sur l'empilement.

Dans un mode de réalisation, l'étape e) de collage s'effectue avec une première couche de collage et une deuxième couche de collage, l'étape e) de collage comprenant les sous-étapes :
e1- déposer la première couche de collage sur le substrat de report ;
e2- déposer la deuxième couche de collage sur l'empilement ;
e3- mettre en contact la première couche de collage et la deuxième couche de collage ; et
e4- chauffer la première couche de collage et la deuxième couche de collage de manière à les coller.

Dans un mode de réalisation, dans l'étape c) de dépôt de la couche tampon sur la couche intermédiaire est effectuée par dépôt physique en phase vapeur (PVD) ou par épitaxie en phase vapeur aux organométalliques (MOCVD).

Dans un mode de réalisation, l'étape d) de dépôt de l'empilement est faite par épitaxie en phase vapeur aux organométalliques (MOCVD).

Dans un mode de réalisation, un matériau de la couche intermédiaire déposée à l'étape b) est configuré pour absorber la lumière ultraviolette, et dans lequel le rayon laser mis en œuvre à l'étape f) est configuré pour émettre de la lumière ultraviolette.

Dans un mode de réalisation, le rayon laser à une longueur d'onde d'émission de 265 nm.

Dans un mode de réalisation, la couche intermédiaire est en TiN et la couche de tampon est en AIN.

Dans un mode de réalisation, une des au moins une couche de collage comprend du titane et/ou du cuivre.

Dans un mode de réalisation, l'étape d) de dépôt dudit empilement réalisant une fonction de diode électroluminescente est configurée pour réaliser une diode électroluminescente émettant dans une plage 200-280 nm.

Dans un mode de réalisation, la couche intermédiaire est en nitrure de métaux de transition choisis parmi : TiN, ZrN, HfN, NbN, TaN, VN.

La description suivante présente plusieurs exemples de réalisation du dispositif de l'invention: ces exemples sont non limitatifs de la portée de l'invention. Ces exemples de réalisation présentent à la fois les caractéristiques essentielles de l'invention ainsi que des caractéristiques additionnelles liées aux modes de réalisation considérés.

### BRÈVE DESCRIPTION DES DESSINS

L'invention sera mieux comprise et d'autres avantages apparaîtront à la lecture de la description qui va suivre donnée à titre non limitatif et grâce aux figures parmi lesquelles :

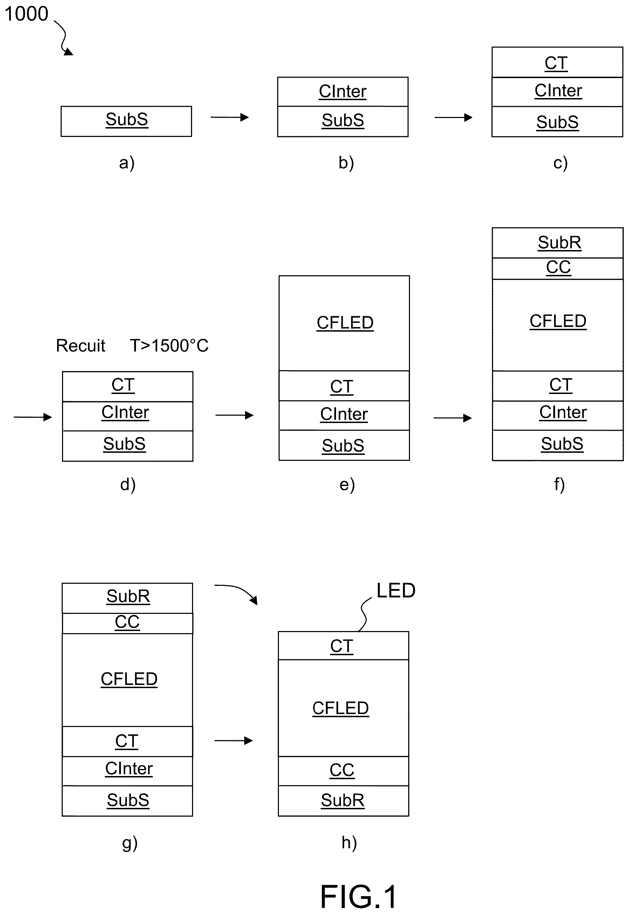

[Fig.1] la figure 1 illustre un procédé de fabrication d'une diode électroluminescente selon l'invention.

### DESCRIPTION DÉTAILLÉE

L'invention concerne un procédé de fabrication d'une diode électroluminescente. La figure 1 illustre un procédé 1000 de fabrication d'une diode électroluminescente LED selon l'invention. Le procédé comprend au moins les étapes a) à f) décrite ci-dessous.

A l'étape a), le procédé 1000 consiste à disposer d'un substrat SubS en saphir.

A l'étape b), le procédé 1000 consiste à déposer une couche dite intermédiaire Clnter sur le substrat SubS de manière à obtenir une couche intermédiaire CInter épitaxiée, la couche intermédiaire étant en nitrure de métaux de transition choisis parmi : TiN, ZrN, HfN, NbN, TaN, VN.

A l'étape c), le procédé 1000 consiste à déposer une couche dite tampon CT sur la couche intermédiaire CInter de manière à obtenir une couche épitaxiée, la couche tampon CT étant en matériau AlxGa1-xN avec 0<x<1.

A l'étape d), le procédé consiste à déposer, sur la couche tampon, un empilement CFLED réalisant une fonction de diode électroluminescente, l'empilement comprenant au moins une couche active (CA), et une couche d'injection (CI1, CI2) de part et d'autre de la couche active.

L'empilement CFLED comprend une première couche d'injection CI1 dopée de type p et une deuxième couche d'injection CL2 dopée de type n.

La couche tampon CT est placée entre l'empilement CFLED et le substrat SubS en saphir. La couche tampon CT permet de faire la transition entre le substrat SubS en saphir et l'empilement CFLED en termes de paramètre de maille. En effet, le paramètre de maille entre le saphir et le matériau actif de la diode électroluminescente compris dans l'empilement CFLED est éloigné, et la couche tampon CT permet ainsi de limiter les défauts qui seraient engendrés par cette différence de paramètre de maille.

A l'étape e) le procédé 1000 consiste à coller un substrat dit de report SubR sur l'empilement grâce à au moins une couche de collage (CC).

A l'étape f) le procédé 1000 consiste à effectuer un détachement par laser (en anglais « lift off ») du substrat SubS en saphir en appliquant un rayon laser RL au moins à travers le substrat SubS en saphir et la couche intermédiaire Clnter, le rayon laser RL ayant une longueur d'onde d'émission configurée pour être absorbée par la couche intermédiaire Clnter. La couche intermédiaire CInter permet donc, via son absorption du rayon laser RL, la mise en œuvre du détachement par laser.

Le procédé selon l'invention permet de bénéficier des avantages d'un substrat saphir pour la croissance et la réalisation de l'empilement CFLED, mais le détachement par la suite de ce substrat permet la réalisation de diodes laser qui émettent dans une longueur qui aurait été absorbée par le substrat saphir. Le détachement permet également de rugosifier la couche tampon CT afin de limiter la réflexion interne des photons.

Avantageusement, l'invention utilise une couche intermédiaire Clnter dont le matériau absorbe dans l'UV, permettant ainsi, en combinaison avec un rayon laser RL émettant également dans l'UV, de réaliser un lift off du substrat SubS en saphir avec une densité d'énergie réduite et en limitant la dégradation des autres couches de la diode électroluminescente. De plus, une couche intermédiaire Clnter dans les matériaux choisis parmi : TiN, ZrN, HfN, NbN, TaN, VN, MoN, WN, CrN permet de faire croitre par épitaxie les différentes couches déposées sur la couche intermédiaire. Ces matériaux absorbent dans l'UV-C. Le matériau de la couche intermédiaire est préférentiellement choisi parmi TiN, ZrN, HfN, NbN, TaN, VN dont la mise en œuvre est plus aisée.

Dans un mode de réalisation, également illustré figure 1 le procédé comprend une étape d') après l'étape d). A l'étape d'), le procédé 1000 consiste à effectuer un recuit du substrat SubS, de la couche tampon CT et de la couche intermédiaire Clnter à une température supérieure à 1500 °C. Le recuit permet de cristalliser la couche tampon CT et de la couche intermédiaire Clnter permettant une croissance de l'empilement CFLED de bonne qualité, c'est-à-dire avec un nombre limité de défauts.

Dans un mode de réalisation, un matériau de la couche intermédiaire déposée à l'étape b) est configuré pour absorber la lumière ultraviolette, et dans lequel le rayon laser RL mis en œuvre à l'étape f) est configuré pour émettre de la lumière ultraviolette.

Dans un mode de réalisation, l'étape d) de dépôt de l'empilement réalisant une fonction de diode électroluminescente CFLED est configurée pour réaliser une diode électroluminescente LED émettant dans une plage 200-280 nm.

Dans un mode de réalisation, l'empilement CFLED comprend au moins une couche de contact, dont au moins une couche de contact est en métal. Par exemple, au moins une couche de contact est déposée entre la couche d'injection supérieure et la couche de collage. On entend par couche d'injection supérieure celle disposée du côté opposé au substrat de saphir par rapport à la couche active. Selon un mode de réalisation une couche de contact est déposée de part et d'autre de l'empilement.

Dans un mode de réalisation, le procédé 1000 comprend en outre le dépôt d'une ou plusieurs couches de transition permettant de limiter les défauts. Par exemple, une couche de transition est déposée, après l'étape c), sur la couche tampon CT. La couche tampon CT et la couche de transition permettent ainsi une transition de maillage entre le saphir et les couches de l'empilement CFLED.

Par exemple, la couche tampon CT est en AIN et la couche active est en GaN. Dans ce cas la couche de transition est en AlGaN, permettant ainsi une transition entre la couche tampon CT et les couches de l'empilement LED en termes de mailles, ce qui limite les défauts.

Dans un mode de réalisation, la couche active de l'empilement CFLED est en puits quantiques, par exemple en puits quantiques AlGaN.

La couche tampon CT comprend une première face en contact avec l'empilement CFLED et une deuxième face opposée à la première face. Selon un mode de réalisation le procédé comprend en outre une étape g) qui consiste à rendre rugueuse (« rugosifier ») la deuxième face de la couche tampon, l'étape h) étant réalisée après l'étape f). Rendre la couche tampon CT rugueuse limite les réflexions internes et permet d'augmenter l'efficacité d'extraction de la lumière de la diode électroluminescente, c'est-à-dire d'augmenter le nombre de photons sortant de la diode.

Dans un mode de réalisation, la couche intermédiaire Cinter a une épaisseur comprise entre 5 et 50 nm. Avantageusement, cette épaisseur permet une forte absorption du rayon laser RL ayant une longueur d'onde dans l'UV, permettant ainsi de réaliser un lift off avec une densité d'énergie du laser réduite, et en limitant les défauts des couches inférieures engendrées par le lift off.

Dans un mode de réalisation, lequel l'étape e) de collage s'effectue en disposant la couche de collage CC sur le substrat de report SubR ou sur l'empilement CFLED.

Dans un premier exemple, la couche de couche de collage CC est disposée seulement sur le substrat de report SubR. Dans ce cas, l'étape e) de collage comprend les sous-étapes suivantes : une étape e1') qui consiste à déposer la couche de collage sur le substrat de report SubR, une étape e2') qui consiste à mettre en contact la couche de collage et l'empilement CFLED, et une étape e3') qui consiste à chauffer la couche de collage de manière à coller l'empilement CFLED et le substrat de report SubR.

Dans un deuxième exemple, la couche de couche de collage CC est disposée seulement sur l'empilement CFLED. Dans ce cas-là, l'étape e) de collage comprenant les sous-étapes suivantes : une étape e1") qui consiste à déposer la couche de collage sur le l'empilement CFLED, une étape e2") qui consiste à mettre en contact la couche de collage et le substrat de report SubR, et une étape e3") qui consiste à chauffer la couche de collage de manière à coller l'empilement CFLED et le substrat de report SubR.

Dans un autre mode de réalisation, l'étape e) de collage s'effectue en disposant d'une première couche de collage et d'une deuxième couche de collage, l'étape e) de collage comprenant les sous-étapes suivantes : une étape e1) qui consiste à déposer la première couche de collage sur le substrat de report SubR, une étape e2) qui consiste à déposer la deuxième couche de collage sur l'empilement CFLED, une étape e3) qui consiste à mettre en contact la première couche de collage et la deuxième couche de collage, et une étape e4) qui consiste à chauffer la première couche de collage et la deuxième couche de collage de manière à les coller. Ainsi, dans cet exemple, deux couches de collage CC sont disposées respectivement sur le substrat de report SubR et sur l'empilement CFLED, qui sont ensuite mis en contact afin de coller le substrat de report SubR sur l'empilement CFLED.

Par exemple, l'étape de chauffe est réalisée à 110 °C.

Dans un mode de réalisation, une des au moins une couche de collage comprend du titane et/ou du cuivre.

Dans un mode de réalisation, l'étape c) de dépôt de la couche tampon CT sur la couche intermédiaire Clnter est effectuée par dépôt physique en phase vapeur (PVD) comme par exemple la pulvérisation cathodique réactive ou l'ablation laser pulsée (PLD) ou par épitaxie en phase vapeur aux organométalliques (MOCVD). Avantageusement, le dépôt par épitaxie en phase vapeur aux organométalliques (MOCVD) permet de limiter les défauts dans la couche tampon CT.

Dans un mode de réalisation, l'étape d) de dépôt de l'empilement CFLED est faite par épitaxie en phase vapeur aux organométalliques (MOCVD). Avantageusement, cela permet de limiter les défauts dans l'empilement CFLED.

Dans un mode de réalisation, le rayon laser RL a une longueur d'onde d'émission de 265 nm. Avantageusement, cela permet d'utiliser une faible densité d'énergie pour effectuer le détachement par laser, n'engendrant pas de dégradation lors de l'étape de détachement.

Dans un mode de réalisation, la couche intermédiaire est en TiN et la couche de tampon est en AIN.

Pour souligner les effets de la couche intermédiaire dans la présente invention, les inventeurs ont réalisés des tests sur deux diodes électroluminescentes obtenues par le procédé 1000 décrit ci-dessus, réalisé avec une couche intermédiaire en TiN de 5 nm et 20 nm respectivement, et sur une diode électroluminescente obtenue par un procédé de fabrication sans l'étape de dépôt de la couche intermédiaire Clnter. Les trois exemples de diodes électroluminescentes possèdent une couche tampon CT en AIN de 400 nm.

Un premier test de diffraction par rayon X a été effectué sur les trois diodes électroluminescentes. Un scan oméga (« rocking curves » en anglais) a été effectué sur les trois diodes électroluminescentes. Les pics de diffraction obtenus par diffraction des rayons X pour deux plans cristallins ont été mesurés et leur largeur à mi-hauteur déterminée. Le tableau 1 ci-dessous divulgue les résultats de la largeur à mi-hauteur des pics déterminée.

Les résultats indiquent clairement que la largeur à mi-hauteur des pics reste environ constante et donc que la couche intermédiaire Clnter ne dégrade pas la cristallinité des couches de la diode électroluminescente.

Un deuxième test de rugosité a été effectué sur les trois diodes électroluminescentes. La moyenne quadratique de la surface en contact avec l'air de la couche tampon CT avant l'étape d), c'est-à-dire avant la croissance de l'empilement CFLED, est mesurée. Le tableau 1 ci-dessus divulgue les résultats de la moyenne quadratique mesurée.

Les résultats indiquent clairement que la moyenne quadratique diminue lorsque la couche intermédiaire Clnter est utilisée pour la fabrication de la diode électroluminescente. Cela signifie que la rugosité de la surface de la couche tampon CT en contact avec l'air diminue lorsque la couche intermédiaire Clnter est utilisée pour la fabrication. Il est nécessaire d'avoir une rugosité minimale afin de croitre un empilement CFLED avec un minimum de défauts.

Ainsi, la couche intermédiaire CInter permet de conserver la cristallinité des couches tout en diminuant la rugosité.

| | AlN 400 nm | TiN 5 nm + AlN 400 nm | TiN 20 nm + AlN 400 nm |
|---|---|---|---|
| largeur pic XRD plan cristallin (002) | 0.21° | 0.23° | 0.25 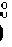 |
| largeur pic XRD plan cristallin (102) | 0.38° | 0.30° | 0.36° |
| RMS | 1.04 nm | 0.77 nm | 0.80 nm |

Tableau 1 : Largeur à mi-hauteurs des pics de diffraction obtenus par diffraction des rayons X pour différents plans cristallins et la moyenne quadratique de la surface de la couche tampon de différents exemples de diodes électroluminescentes obtenues avec ou sans couche intermédiaire en TiN

Il est noté que dans la description précédente, on entend par épitaxie un procédé de croissance ordonnée.

Bien que l'invention ait été illustrée et décrite en détail à l'aide d'un mode de réalisation préféré, l'invention n'est pas limitée aux exemples divulgués. D'autres variantes peuvent être déduites par l'homme du métier sans sortir du cadre de protection de l'invention revendiquée.

## Revendications

1. Procédé (1000) de fabrication d'une diode électroluminescente (LED), le procédé comprenant les étapes suivantes :
a- disposer d'un substrat (SubS) en saphir ;
b- déposer une couche dite intermédiaire (Clnter) sur le substrat de manière à obtenir une couche intermédiaire épitaxiée, la couche intermédiaire étant en nitrure de métaux de transition choisis parmi : TiN, ZrN, HfN, NbN, TaN, VN, MoN, WN, CrN ;
c- déposer une couche dite tampon (CT) sur la couche intermédiaire de manière à obtenir une couche épitaxiée, la couche tampon étant en matériau AlₓGa₁₋ₓN avec 0≤x≤1 ;
d- déposer, sur la couche tampon, un empilement (CFLED) réalisant une fonction de diode électroluminescente, l'empilement comprenant au moins une couche active (CA), et une couche d'injection (CI1, CI2) de part et d'autre de la couche active ;
e- coller un substrat dit de report (SubR) sur l'empilement grâce à au moins une couche de collage (CC) ; et
f- effectuer un détachement par laser du substrat en saphir en appliquant un rayon laser au moins à travers le substrat en saphir et la couche intermédiaire, le rayon laser (RL) ayant une longueur d'onde d'émission configurée pour être absorbée par la couche intermédiaire.

2. Procédé selon la revendication 1, le procédé comprenant en outre l'étape suivante, réalisée après l'étape d) :
d'- effectuer un recuit du substrat, de la couche tampon et de la couche intermédiaire à une température supérieure à 1500 °C ;

3. Procédé selon la revendication 1 ou 2, la couche tampon comprenant une première face en contact avec l'empilement et une deuxième face opposée à la première face, le procédé comprenant en outre l'étape suivante, réalisée après l'étape f) :
g- rendre rugueuse la deuxième face de la couche tampon ;

4. Procédé selon l'une des revendications précédentes, dans laquelle la couche intermédiaire (Cinter) a une épaisseur comprise entre 5 et 50 nm.

5. Procédé selon l'une des revendications précédentes, dans lequel l'étape e) de collage s'effectue en disposant une couche de collage sur le substrat de report ou sur l'empilement.

6. Procédé selon l'une des revendications 1 à 3, dans lequel l'étape e) de collage s'effectue avec une première couche de collage et une deuxième couche de collage, l'étape e) de collage comprenant les sous-étapes :
e1- déposer la première couche de collage sur le substrat de report ;
e2- déposer la deuxième couche de collage sur l'empilement ;
e3- mettre en contact la première couche de collage et la deuxième couche de collage ; et
e4- chauffer la première couche de collage et la deuxième couche de collage de manière à les coller.

7. Procédé selon l'une des revendications précédentes, dans lequel l'étape c) de dépôt de la couche tampon sur la couche intermédiaire est effectuée par dépôt physique en phase vapeur (PVD) ou par épitaxie en phase vapeur aux organométalliques (MOCVD).

8. Procédé selon l'une des revendications précédentes, dans lequel l'étape d) de dépôt de l'empilement est faite par épitaxie en phase vapeur aux organométalliques (MOCVD).

9. Procédé selon l'une des revendications précédentes, dans lequel un matériau de la couche intermédiaire déposée à l'étape b) est configuré pour absorber la lumière ultraviolette, et dans lequel le rayon laser (RL) mis en œuvre à l'étape f) est configuré pour émettre de la lumière ultraviolette.

10. Procédé selon la revendication précédente, dans lequel le rayon laser à une longueur d'onde d'émission de 265 nm.

11. Procédé selon l'une des revendications précédentes, dans lequel la couche intermédiaire est en TiN et la couche de tampon est en AIN.

12. Procédé selon l'une des revendications précédentes, dans lequel une des au moins une couche de collage comprend du titane et/ou du cuivre.

13. Procédé selon l'une des revendications précédentes, dans lequel l'étape d) de dépôt dudit empilement réalisant une fonction de diode électroluminescente est configurée pour réaliser une diode électroluminescente émettant dans une plage 200-280 nm.

14. Procédé selon l'une des revendications précédentes, dans lequel la couche intermédiaire est en nitrure de métaux de transition choisis parmi : TiN, ZrN, HfN, NbN, TaN, VN.
